# EUROPEAN PATENT APPLICATION

(11) **EP 2 824 461 A1**
(43) Date of publication of application: **14.01.2015**
(21) Application number: 14176251.8
(22) Date of filing: 09.07.2014
(51) Int. Cl.: G01R 13/02

(54) **Frame analysis - a new way to analyze serial and other packetized data**

(30) Priority: 09.07.2013 US 201313937560
(71) Applicant: Tektronix, Inc., Beaverton, Oregon 97077-0001 (US)
(72) Inventor: Ramchandran, Ashok, Beaverton, OR Oregon 97077-0001 (US)
(74) Representative: Clarke, Jeffrey David

(57) **Abstract**

An aspect of the invention includes a machine (105). The machine can receive data (130) and determine a logical subdivision (135) of the data. The machine can then identify frames (140) within the data, based on the logical subdivision of the data. The machine can then display (115) the frames to the user for visual comparison.

## Description

### FIELD OF THE INVENTION

This disclosure pertains to data analysis, and more particularly to a new way to analyze packetized or serial data.

### BACKGROUND

Currently, data analysis of signals or other serial data is limited. Oscilloscopes can view a signal as a whole. If the user wants to examine packets of data individually, the oscilloscope lets the user navigate the packets. But the user must navigate through all of the packets in the signal, making it difficult to find a particular packet of interest. In addition, the oscilloscope must process every packet as the user navigates through the packets, which slows down analysis. Essentially, a user can view one waveform at a time on the oscilloscope; any more involved analysis requires the user to remember things that can easily be forgotten or misremembered.

A need remains for a way to address these and other problems associated with the prior art.

### SUMMARY OF THE INVENTION

Aspects of the invention include a machine. The machine can receive data, which can be subdivided into frames, each frame representing one or more units of a logical subdivision of the data. Two frames can then be visually compared using the machine.

### BRIEF DESCRIPTION OF THE DRAWINGS

FIG. 1 shows a machine enabling a user to compare frames in serial or packetized data, according to an embodiment of the invention.
FIG. 2 shows data received by the machine of FIG. 1 being divided into frames.
FIG. 3 shows the filter of FIG. 1 filtering the data to reduce the number of frames the user might view.
FIGs. 4A and 4B show the operator of FIG. 1 operating on one or more frames to produce results.
FIG. 5 shows the frame adjuster of FIG. 1, which can adjust frames to different start points to correct for misalignment.
FIG. 6 shows the machine of FIG. 1 displaying two waveforms, in both raw and interpreted form, for visual comparison by the user.
FIGs. 7A-7B show a flowchart of a procedure to use the machine of FIG. 1 to compare frames, according to an embodiment of the invention.
FIG. 8 shows a flowchart of a procedure for visually comparing frames in different ways.
FIG. 9 shows a flowchart of a procedure for filtering frames of data in different ways.
FIG. 10 shows a flowchart of a procedure for correcting frames for misalignment.
FIG. 11 shows a flowchart of a procedure for copying the result of an operation on a frame for identical frames.

### DETAILED DESCRIPTION

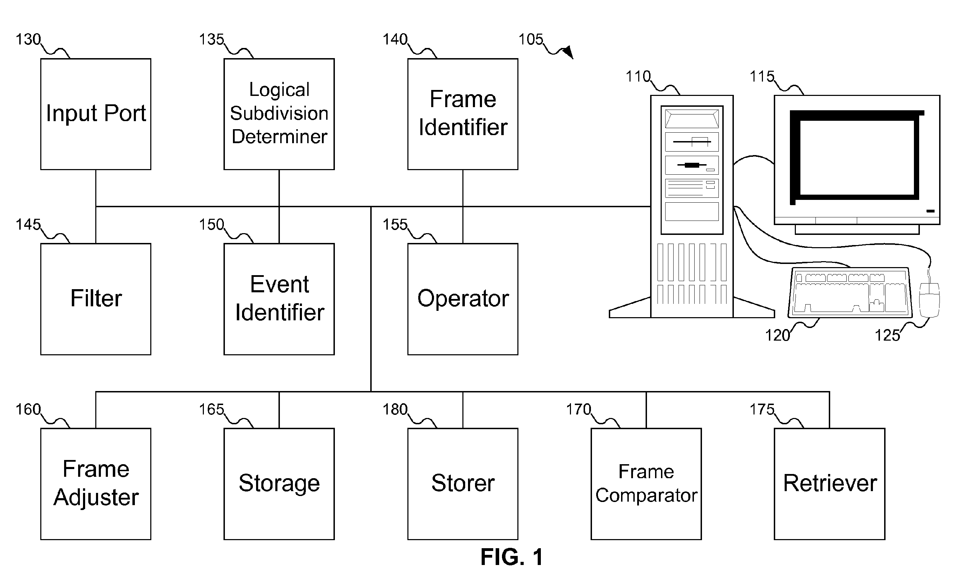

FIG. 1 shows a machine enabling a user to compare frames in serial or packetized data, according to an embodiment of the invention. Packetized data is data that can be broken logically into a number of related units, which can be termed "packets". In FIG. 1, machine 105 is shown as a computer system, including computer 110, monitor 115, keyboard 120, and mouse 125. A person skilled in the art will recognize that other components can be included with machine 105: for example, other input/output devices, such as a printer. In addition, FIG machine 105 can include conventional internal components not shown in FIG. 1: for example, central processing unit, memory, storage, etc. In addition, although not shown in FIG. 1, a person skilled in the art will recognize that machine 105 can interact with other machines, either directly or over a network (not shown) of any type. Finally, although FIG. 1 shows machine 105 as a conventional desktop computer, a person skilled in the art will recognize that machine 105 can be any type of machine or computing device capable of providing the services attributed herein to machine 105, including, for example, a laptop computer, a personal digital assistant (PDA), a cellular telephone, or a suitably designed oscilloscope.

Machine 105 includes various modules. Input port 130 receives data. Input port 130 can receive data from the user or from another source: for example, from another machine, or from a sensor tapped into a network, among other possibilities. Logical subdivision determiner 135 can determine a logical subdivision for the data. The form the logical subdivision takes can depend on the data itself. For example, data travelling over a network is usually packetized, so the logical subdivision can be a packet. For video data, an individual frame of the video can be a logical subdivision. For waveform data, logical subdivisions can include a number of cycles, a specified time duration, a pulse, or specific characteristics of a pulse, such as a predetermined rate and/or size. In addition, the waveform that specifies the logical subdivision can be part of the data, or it can be an alternate, secondary signal. A person skilled in the art will recognize other forms that the data can take, and what could constitute a logical subdivision of such data.

Frame identifier 140 can identify individual frames within the data, based on the logical subdivision as determined by logical subdivision determiner 135. For example, if the logical subdivision is a packet, frame identifier 140 can identify individual packets within the data. If the logical subdivision is a video frame, frame identifier 140 can identify individual video frames in the data. If the logical subdivision is a pulse, frame identifier 140 can identify individual pulses in the data. And so on.

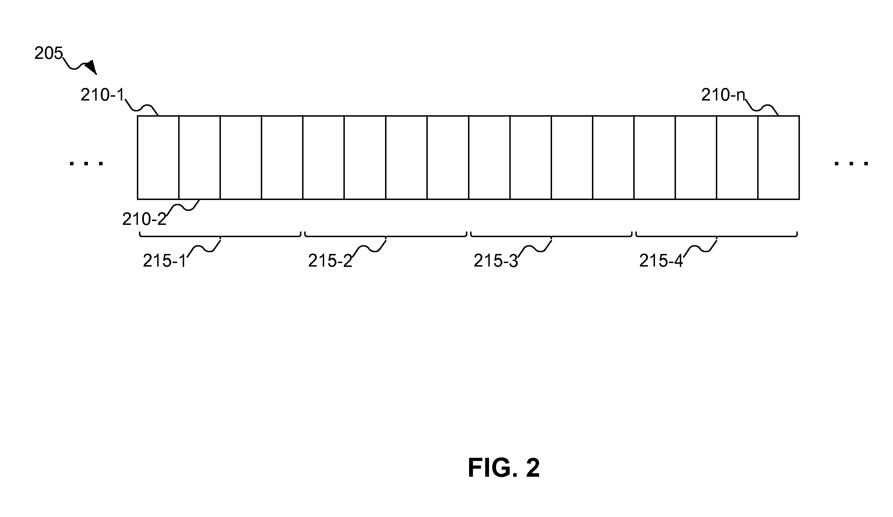

FIG. 2 shows data received by the machine of FIG. 1 being divided into frames. In FIG. 2, data 205 is shown as including various pieces of data, such as pieces 210-1, 210-2, and so on up to piece 210-*n*. These pieces can be any desired subset of data 205: for example, individual bits or bytes, or even higher-level concepts, such as packets. These pieces of data can be organized into logical subdivisions, as discussed above. For example, if data 205 represents video data, pieces 210-1, 210-2, and 210-*n* can represent packets, which can be organized into video frames, such as frames 215-1, 215-2, 215-3, and 215-4. A person of ordinary skill in the art will recognize how data of other forms can be divided into frames in a comparable manner.

Once frames have been identified, the user can visually review the frames. For example, the user can visually scan the frames, to look for a frame that appears to have a problem. The user can also visually zoom in on and inspect individual frames. The user can also review the frames in a non-visual manner. Any discussion in this document that refers to visual review by the user is to be understood as also encompassing non-visual review.

FIG. 2 shows frames as discrete, non-overlapping sections of the data, and often this will be the case. But it is possible that the logical subdivision of the data can produce many different frame structures, which can overlap. For example, frames can start at the beginning of each piece 210-1, 210-2, 210-*n*, and so on, each including four pieces of data. In such a situation, frames can overlap.

Returning to FIG. 1, filter 145 can filter the data. Filtering the data provides a way of reducing the amount of data that the user needs to review in analyzing the data. There are many different ways in which filtering can occur. One way filtering can occur is the user can provide information that is pertinent to the frames of interest, and filter 145 can eliminate any frames that do not include pertinent data. Examples of this can include filtering packets based on information in the header of the packets (e.g., filtering out packets that are not sent from a particular source IP address, or sent to a particular destination IP address), filtering packets of video data based on line numbers, or filtering pulses in a waveform based on waveform characteristics, such as amplitude-related criteria (e.g., maximum or minimum amplitude, Root Mean Square (RMS), greater or less than a predetermined value, etc.) or time-related criteria (e.g., frequency, period, rise-time, etc.). These characteristics can apply to the entirety of the waveform in the frame, which can include multiple cycles in the data. These examples are not limiting, and packets, video data, and waveforms can all be filtered in other ways. Filtering the data is optional: the user can review the data without filtering the data.

Another way in which filter 145 can operate is to eliminate dead time in the data. For example, in a packet stream, the packets that contain pertinent data might be transmitted only sporadically, with nothing being transmitted in the gaps. This dead time can be filtered out from the data.

Yet another way in which filter 145 can operate is to identify frames that are of interest to the user. For example, the user can identify a particular frame as of interest, and can request machine 105 to find all frames that are within some threshold difference of the given frame. Filter 145 can then examine the frames in the data and eliminate all frames that are not within the threshold difference of the given frame.

Yet another way in which filter 145 can operate is to identify frames associated with an event. Machine 105 can receive an event of interest (for example, received from the user) using event identifier 150. Event identifier 150 can operate to capture an event in any desired manner. For example, event identifier 150 can identify an event as the source of the data (e.g., the source IP address in the header information of packets in the data). Filter 145 can then eliminate any frames that are not associated with the event.

The user can also manually filter the data. For example, the user might want to manually select frames of interest for later review.

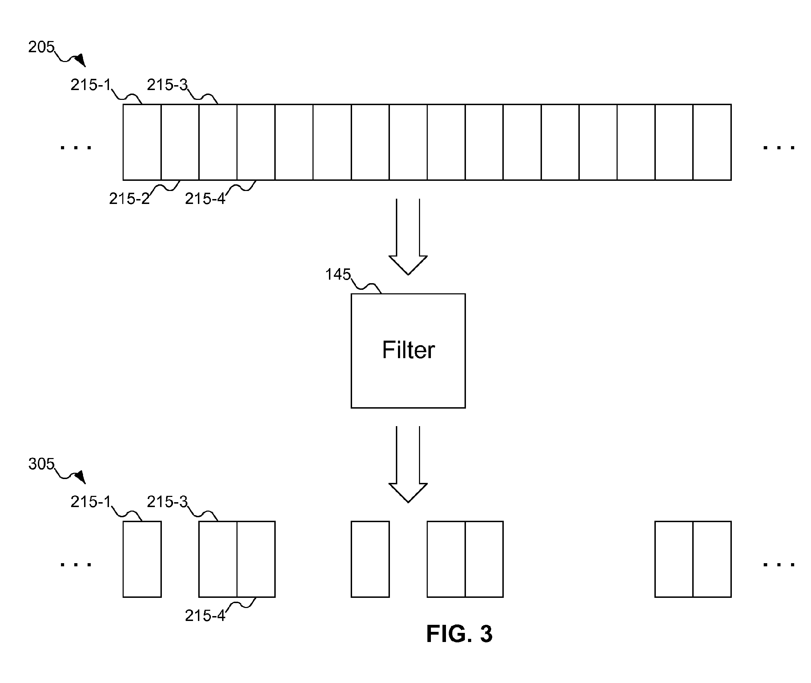

FIG. 3 shows the filter of FIG. 1 filtering the data to reduce the number of frames the user might view. In FIG. 3, data 205 is shown as a series of frames, including, among other frames, frames 215-1, 215-2, 215-3, and 215-4. Filter 145 operates on data 205 to produce filtered data 305, which includes only those frames that are not eliminated by filter 145. Thus, for example, filtered data 305 includes frames 215-1, 215-3, and 215-4, but not frame 215-2.

Returning to FIG. 1, operator 155 can perform an operation on a subset of the data (e.g., one or more frames, including possibly every individual frame), or on the data as a whole. Examples of such operators can include transforms, such as a Fourier transform. Operator 155 can also perform operations on two sets of data. For example, operator 155 can compare two sets of data by subtracting one from the other, to isolate the differences. As with operations on only one data, such operations can work on two data streams as a whole, or on subsets of the data, such as two frames.

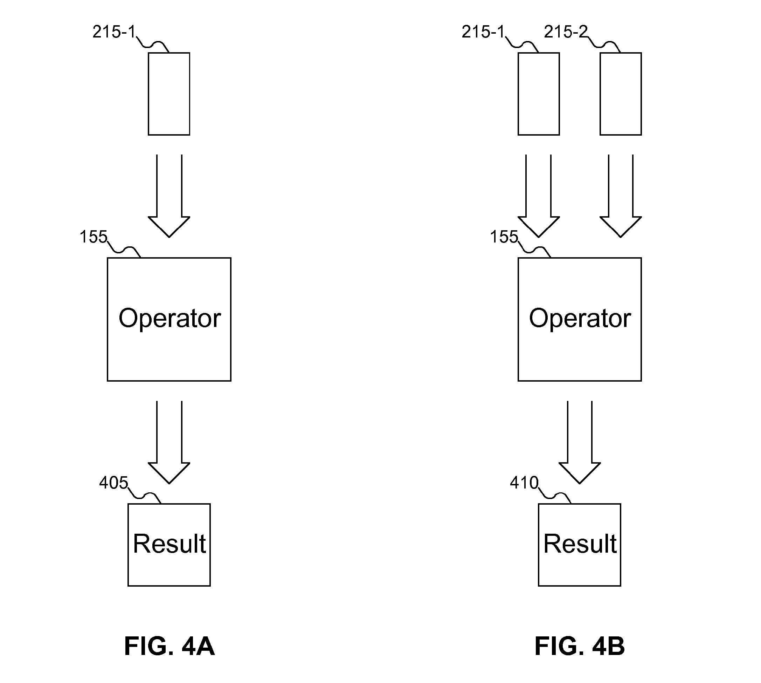

FIGs. 4A and 4B show the operator of FIG. 1 operating on one or more frames to produce results. In FIG. 4A, operator 155 is shown as operating on frame 215-1, producing result 405. For example, if operator 155 is performing a Fourier transform, result 405 is the result of performing the Fourier transform on frame 215-1. In FIG. 4B, operator 155 is shown as operating on two frames 215-1 and 215-2, and producing result 410. As discussed above, operator 155 can be comparing frames 215-1 and 215-2, with result 410 being the difference between the two input frames.

Once calculated, the results of operator 155, whether result 405 of FIG. 4A or result 410 or FIG. 4B, can be presented to the user. The user can then use the result as part of the analysis of frames in the data. Thus, the results of operator 155 can also be visually presented to the user.

The results of operations on frames can themselves be considered frames. Thus, additional operations can be performed on results 405 and 410. For example, a Fourier transform can be performed on each frame in the data, and then statistical operations, such as variations between the frames, the standard deviation of the frames, the mean of the frames, or the maximum or minimum of the frames, can be performed on the results.

Returning to FIG. 1, frame adjuster 160 can adjust the start point of frames, to correct for possible misalignment. For example, if the input data is a video, the frames would be ideally aligned with the start of a single frame in the video, and would have a known size. But if the data were corrupted slightly - for example, a few bits were missing from one frame - then one frame would include a few bits actually belonging to the next frame, and this error would propagate through the remainder of the data. By correcting for the misalignment, the frames of the data can be used more effectively.

Frame adjuster 160 can use various different approaches to correct for misalignment of frames. For example, if a frame has a known start point, frame adjuster 160 can simply change the start point of the frame to the known good start point. Alternatively, frame adjuster 160 can attempt to calculate an adjustment to a frame that minimizes the misalignment.

As an example of how frame adjuster 160 can correct such a misalignment, consider the situation in which the user has identified two frames. Frame adjuster can then try various corrections to one or both frames, and then calculate the differences between the frames as adjusted using the various corrections. Frame adjuster 160 can then identify which correction resulted in a minimum difference between the corrected frames, and can use the adjustments that produced that minimum difference as the correction for the misalignment.

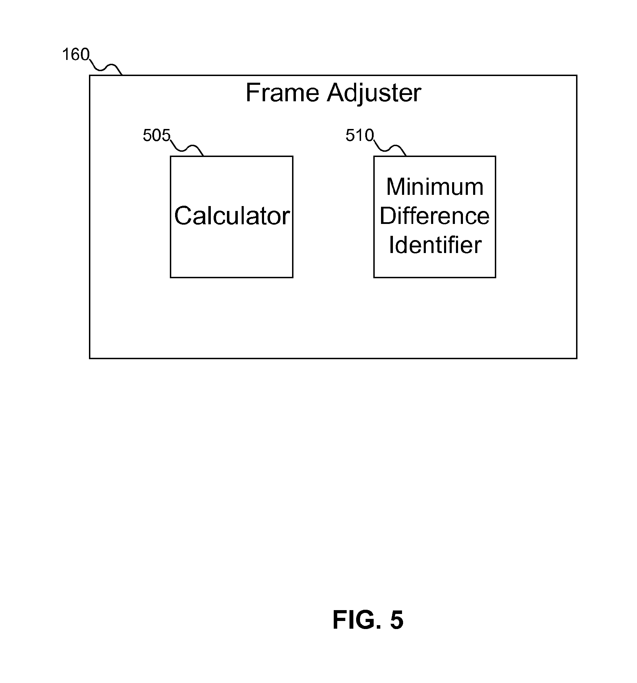

FIG. 5 shows the frame adjuster of FIG. 1, which can adjust frames to different start points to correct for misalignment. In FIG. 5, frame adjuster 160 includes calculator 505, which can calculate the difference between two frames given adjustments made to one or both frames. Minimum difference identifier 510 can identify a minimum difference between two adjusted frames, so that a correction to the misaligned frames can be determined.

Frame adjustment can also be done manually. In some situations, the user might know best how to adjust the frames to correct for misalignment. Frame adjuster 160 can also permit the user to manually adjust the start point of the frames.

Returning to FIG. 1, machine 105 can also include storage 165, frame comparator 170, and retriever 175. Storage 165 can be used to store a frame and the result of an operation (using operator 155) on the frame. Storer 180 can store data in storage 165, such as the frame and the result of the operation. Frame comparator 170 can compare two frames to determine if they are identical (that is, the frames include the same data). Assuming that two frames are identical, retriever 175 can be used to retrieve the result of an operation performed on one frame, so that the result can then be stored as the result of the operation performed on the identical frame (also using storer 180). In this manner, machine 105 avoids the need to perform the operation twice on the same data. (This sequence assumes that the operation will produce the same results on the same data: if the operation produces different results on the same data, then this sequence would not work.)

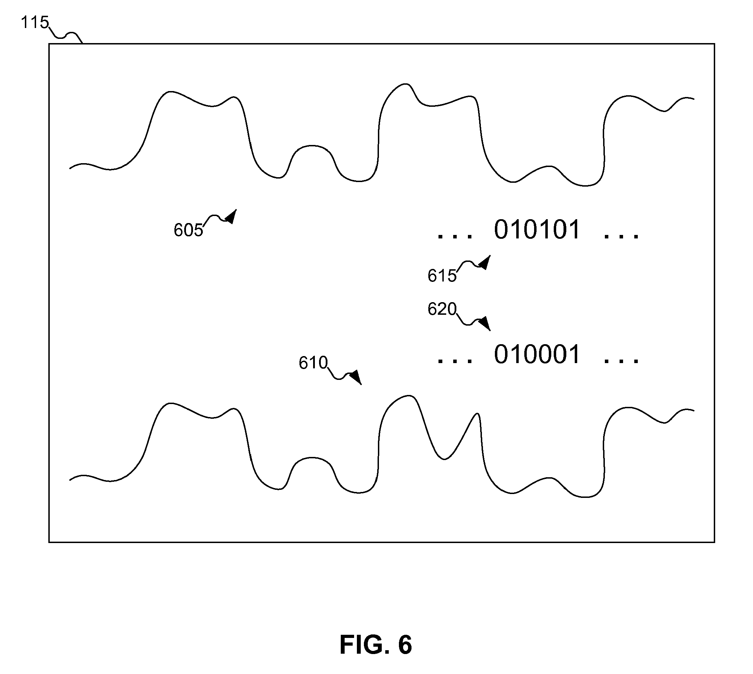

As discussed above, embodiments of the invention enable a user to compare multiple data visually. FIG. 6 shows the machine of FIG. 1 displaying two waveforms, in both raw and interpreted form, for visual comparison by the user. In FIG. 6, waveforms 605 and 610 are shown on monitor 115. Waveforms 605 and 610 can be two different waveforms, or they can be frames from a single data. Because both have been selected by the user, they are both displayed to the user, so that the user can visually compare the waveforms.

In addition to waveforms 605 and 610, which are raw data - the signal as actually accessed from the network - the machine can also display interpreted data for each waveform. For example, monitor 115 is also shown displaying interpreted data 615 and 620. For example, if waveforms 605 and 610 show the signals transmitted over a network, interpreted data 615 and 620 can represent the bits as encoded in the signals. While FIG. 6 shows interpreted data 610 and 620 as bits, a person skilled in the art will recognize that interpreted data 615 and 620 can also show the data interpreted at a higher level: for example, at the packet level, or at the application level (e.g., interpreting the data as the application that processes the data would interpret it). A person skilled in the art will also recognize that other forms of data aside from waveforms 605 and 610 can be the raw data to be interpreted.

In some situations, the user might want to compare frames within a single data. But in other situations, the user might want to compare frames within the data with frames from some other source. For example, another machine might be showing one or more frames of interest to the user, and which the user wants to compare against frames in the data. The machine can import the frame or frames from the other machine for use in comparison with frames in the data or to find a frame within the data that is "closest" to the imported frame(s).

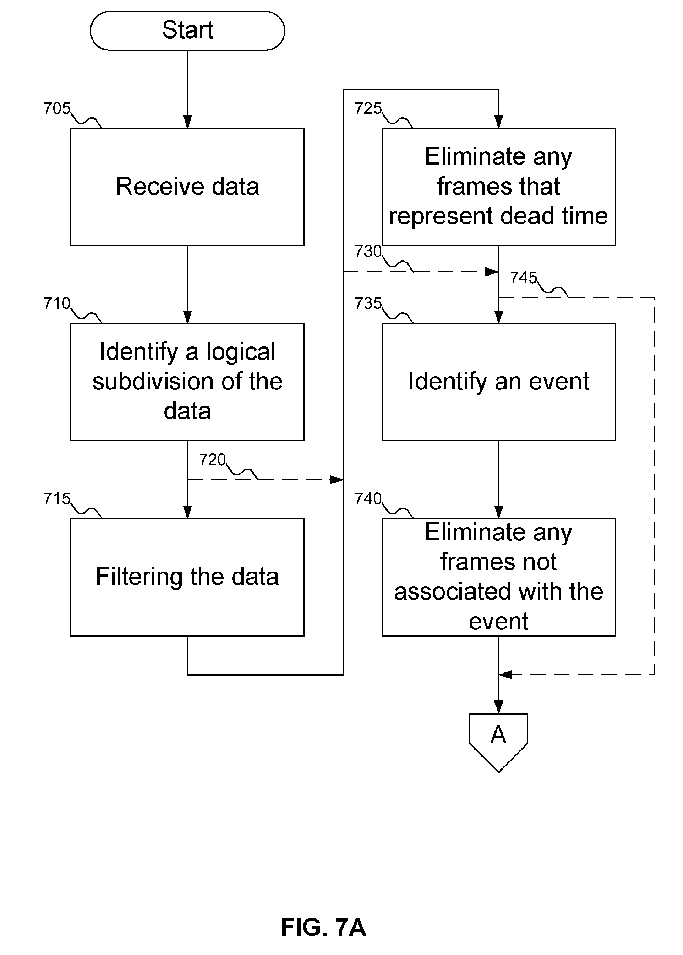

FIGs. 7A-7B show a flowchart of a procedure to use the machine of FIG. 1 to compare frames, according to an embodiment of the invention. In FIG. 7A, at block 705, the system received data. At block 710, the system identifies a logical subdivision of the data. At block 715, the system can filter the data based on the logical subdivision of the data. As shown by dashed arrow 720, block 715 can be omitted. At block 725, any frames that represent dead time can be eliminated. As discussed above with reference to FIG. 1, eliminating dead time can be part of filtering the data. As shown by dashed arrow 730, block 725 can be omitted. At block 735, the system identifies an event. At block 740, the system can eliminate any frames not associated with the event. As discussed above with reference to FIG. 1, eliminating frames not associated with an event can be part of filtering the data. As shown by dashed arrow 745, blocks 735 and 740 can be omitted.

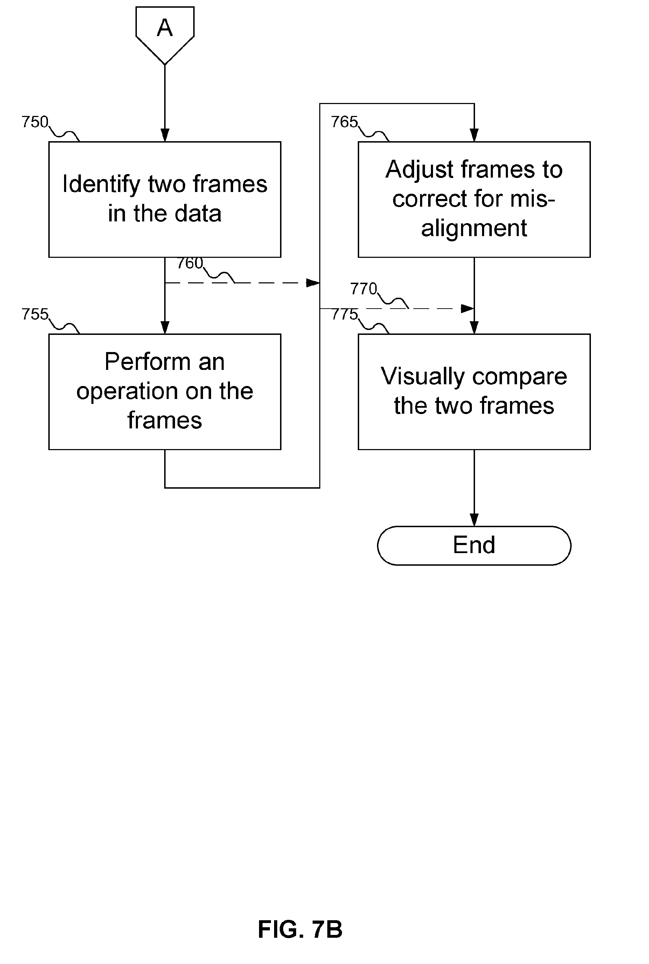

At block 750 (FIG. 7B), the system can identify two frames in the data. At block 755, the system can perform operations on the frames. As discussed above with FIGs. 4A and 4B, the operations can be performed on the frames individually or collectively. As shown by dashed arrow 760, block 755 can be omitted. At block 765, the system can adjust the frames to correct for misalignment. As shown by dashed arrow 770, block 765 can be omitted. Finally, at block 775, the system can present the frames to the user for visual comparison.

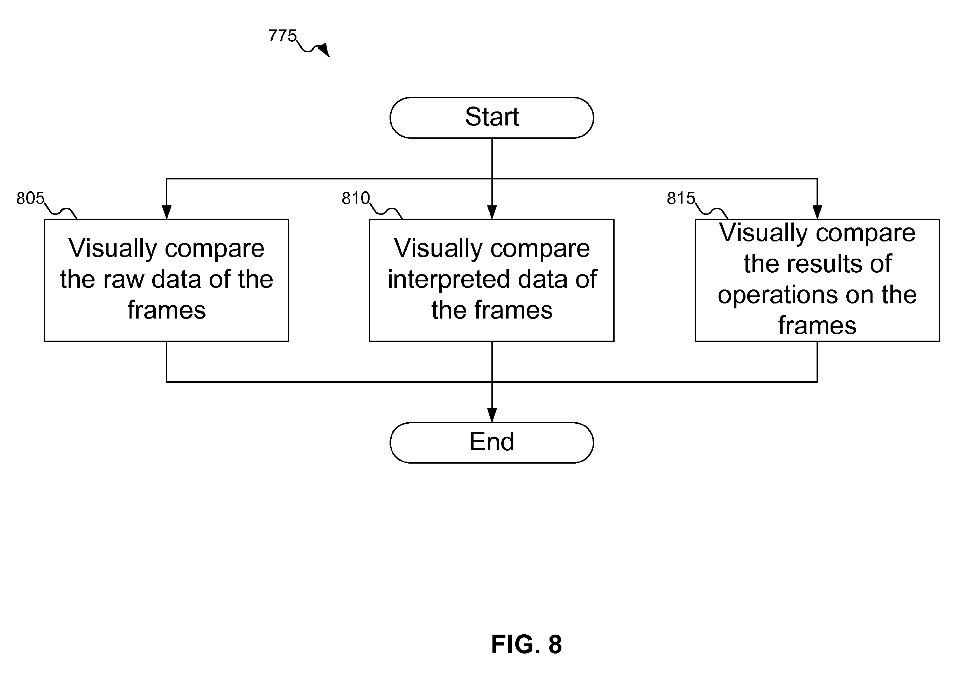

FIG. 8 shows a flowchart of a procedure for visually comparing frames in different ways. In FIG. 8, at block 805, the system can present the raw data of the frames for visual comparison. Alternatively, at block 810, the system can present interpreted data of the frames for visual comparison. Alternatively, at block 815, the system can present the results of operations on the frames for visual comparison. A person skilled in the art will recognize that blocks 805, 810, and 815 are not mutually exclusive, and can be performed in any desired combination.

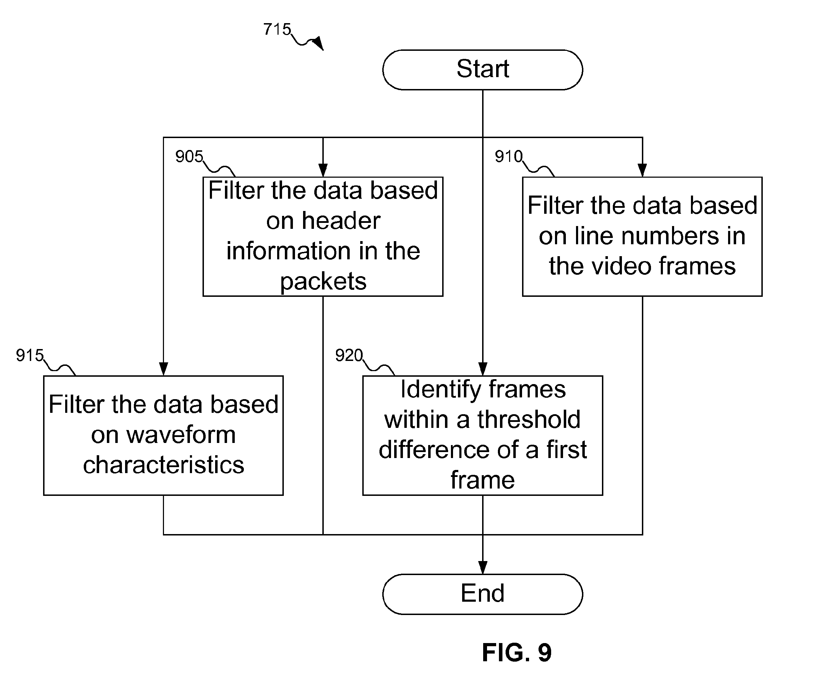

FIG. 9 shows a flowchart of a procedure for filtering frames of data in different ways. In FIG. 9, at block 905, the system can filter packet data based on information in the header of the packets. Alternatively, at block 910, the system can filter video data based on line numbers in the video frames. Alternatively, at block 915, the system can filter waveform data based on waveform characteristics, as described above with reference to FIG. 1. Alternatively, at block 920, the system can identify frames in the data that are within a threshold distance of a given frame.

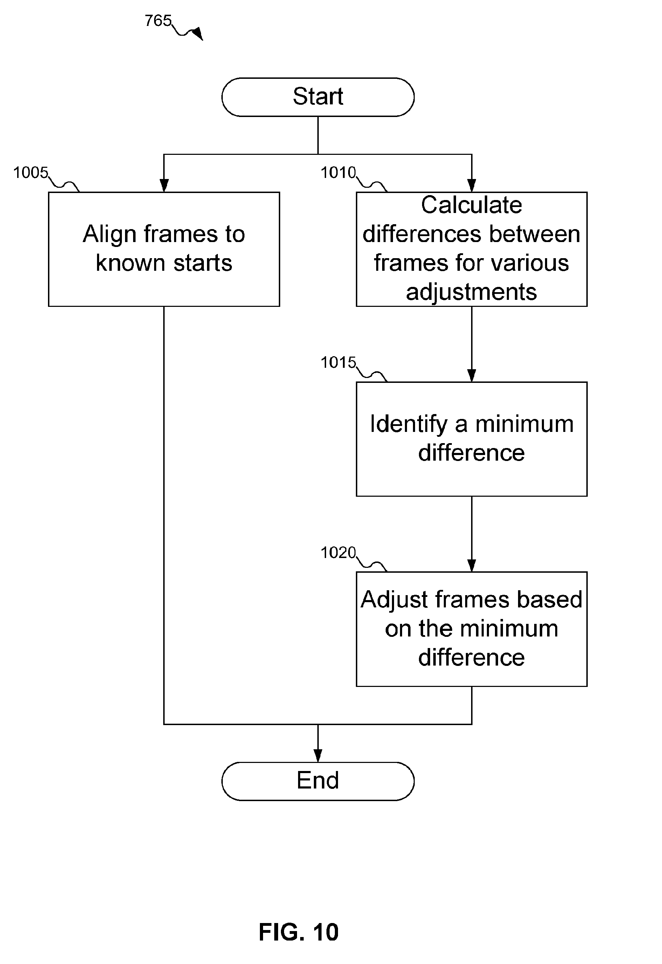

FIG. 10 shows a flowchart of a procedure for correcting frames for misalignment. In FIG. 10, at block 1005, the system can align a frame to a known start for the frame. Alternatively, at block 1010, the system can calculate the difference between frames given various adjustments, at block 1015, the system can identify which such calculated difference is the minimum distance, and at block 1020, the system can adjust the frames based on the identified minimum difference.

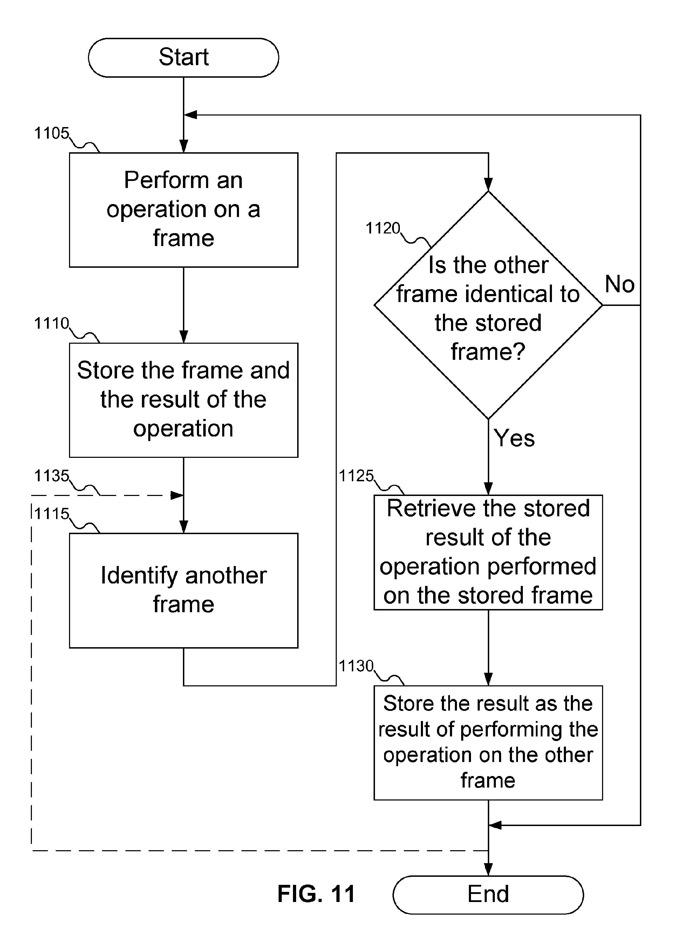

FIG. 11 shows a flowchart of a procedure for copying the result of an operation on a frame for identical frames. In FIG. 11, at block 1105, the system performs an operation on a frame. At block 1110, the system stores the frame and the result of the operation on the frame. At block 1115, the system identifies another frame. At block 1120, the system compares the new frame with the earlier stored frame to determine if they are identical. If so, then at block 1125, the system retrieves the result of the operation on the stored frame, and at block 1130, the system stores that result as the result of performing the operation on the new frame.

While FIG. 11 shows the system comparing the new frame with only one stored frame, a person skilled in the art will recognize that embodiments of the claimed invention can perform operations on any number of frames and store the results, and can compare a new frame with any number of stored frames, even every stored frame, to determine if there is a match anywhere. If there is a match, the blocks 1125 and 1130 can be performed based on the matched frame. Thus, if there is no match in block 1120, the system can return to block 1105 to perform the operation on the new frame and store the result, or blocks 1125 and 1130 can be skipped (either to locate another new frame, as shown by dashed line 1135, or to end processing).

Although the above discussion describes comparing two frames, embodiments of the claimed invention are not limited to comparing only two frames. For example, a frame from the data can be compared with two frames imported from another source, or an imported frame can be compared with two frames from the data. Embodiments of the invention can be generalized to any number of frames being compared in the described manner.

The following discussion is intended to provide a brief, general description of a suitable machine in which certain aspects of the invention may be implemented. Typically, the machine includes a system bus to which is attached processors, memory, e.g., random access memory (RAM), read-only memory (ROM), or other state preserving medium, storage devices, a video interface, and input/output interface ports. The machine may be controlled, at least in part, by input from conventional input devices, such as keyboards, mice, etc., as well as by directives received from another machine, interaction with a virtual reality (VR) environment, biometric feedback, or other input signal. As used herein, the term "machine" is intended to broadly encompass a single machine, or a system of communicatively coupled machines or devices operating together. Exemplary machines include computing devices such as personal computers, workstations, servers, portable computers, handheld devices, telephones, tablets, etc., as well as transportation devices, such as private or public transportation, e.g., automobiles, trains, cabs, etc.

The machine may include embedded controllers, such as programmable or non-programmable logic devices or arrays, Application Specific Integrated Circuits, embedded computers, smart cards, and the like. The machine may utilize one or more connections to one or more remote machines, such as through a network interface, modem, or other communicative coupling. Machines may be interconnected by way of a physical and/or logical network, such as an intranet, the Internet, local area networks, wide area networks, etc. One skilled in the art will appreciated that network communication may utilize various wired and/or wireless short range or long range carriers and protocols, including radio frequency (RF), satellite, microwave, Institute of Electrical and Electronics Engineers (IEEE) 810.11, Bluetooth, optical, infrared, cable, laser, etc.

The invention may be described by reference to or in conjunction with associated data including functions, procedures, data structures, application programs, etc. which when accessed by a machine results in the machine performing tasks or defining abstract data types or low-level hardware contexts. Associated data may be stored in, for example, the volatile and/or non-volatile memory, e.g., RAM, ROM, etc., or in other storage devices and their associated storage media, including hard-drives, floppy-disks, optical storage, tapes, flash memory, memory sticks, digital video disks, biological storage, etc. Associated data may be delivered over transmission environments, including the physical and/or logical network, in the form of packets, serial data, parallel data, propagated signals, etc., and may be used in a compressed or encrypted format. Associated data may be used in a distributed environment, and stored locally and/or remotely for machine access.

Having described and illustrated the principles of the invention with reference to illustrated embodiments, it will be recognized that the illustrated embodiments may be modified in arrangement and detail without departing from such principles. And, though the foregoing discussion has focused on particular embodiments, other configurations are contemplated. In particular, even though expressions such as "in one embodiment" or the like are used herein, these phrases are meant to generally reference embodiment possibilities, and are not intended to limit the invention to particular embodiment configurations. As used herein, these terms may reference the same or different embodiments that are combinable into other embodiments.

Embodiments of the invention can extend to the following statements, without limitation:
An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; and a monitor to permit a user to visually compare said first frame with said second frame.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; and a monitor to permit a user to visually compare said first frame with said second frame, wherein said first frame is imported from a second machine.

An embodiment of the invention includes a system, comprising: a machine; an input port on the machine to receive data; a logical subdivision determiner to identify a logical subdivision of said data, said logical subdivision including a packet; a filter to filter said data based on at least one of header information and data content in packets in said data; a frame identifier to identify a first frame and a second frame in said data, said first frame and said second frame each including one unit of said logical subdivision of said data and said first frame and said second frame do not overlap; and a monitor to permit a user to visually compare said first frame with said second frame.

An embodiment of the invention includes a system, comprising: a machine; an input port on the machine to receive data; a logical subdivision determiner to identify a logical subdivision of said data, said logical subdivision including a video frame; a filter to filter said data based on at least one of line numbers and video content in video frames in said data; a frame identifier to identify a first frame and a second frame in said data, said first frame and said second frame each including one unit of said logical subdivision of said data and said first frame and said second frame do not overlap; and a monitor to permit a user to visually compare said first frame with said second frame.

An embodiment of the invention includes a system, comprising: a machine; an input port on the machine to receive data; a logical subdivision determiner to identify a logical subdivision of said data, said logical subdivision including a waveform, the waveform based on at least one of a number of cycles, a specified time duration, and a pulse including specific characteristics; a filter to filter said data based on a waveform characteristic; a frame identifier to identify a first frame and a second frame in said data, said first frame and said second frame each including one unit of said logical subdivision of said data and said first frame and said second frame do not overlap; and a monitor to permit a user to visually compare said first frame with said second frame.

An embodiment of the invention includes a system, comprising: a machine; an input port on the machine to receive data; a logical subdivision determiner to identify a logical subdivision of said data, said logical subdivision including a waveform, the waveform based on at least one of a number of cycles, a specified time duration, and a pulse including specific characteristics; a filter to filter said data based on a waveform characteristic; a frame identifier to identify a first frame and a second frame in said data, said first frame and said second frame each including one unit of said logical subdivision of said data and said first frame and said second frame do not overlap; and a monitor to permit a user to visually compare said first frame with said second frame, wherein the waveform used to identify the logical subdivision of the data is received from an alternate, secondary signal.

An embodiment of the invention includes a system, comprising: a machine; an input port on the machine to receive data; a logical subdivision determiner to identify a logical subdivision of said data; a filter to identify said second frame as being within a threshold of difference from said first frame; a frame identifier to identify a first frame and a second frame in said data, said first frame and said second frame each including one unit of said logical subdivision of said data and said first frame and said second frame do not overlap; and a monitor to permit a user to visually compare said first frame with said second frame.

An embodiment of the invention includes a system, comprising: a machine; an input port on the machine to receive data; a logical subdivision determiner to identify a logical subdivision of said data; a filter to identify said second frame as a frame in the data that is closest to said first frame; a frame identifier to identify a first frame and a second frame in said data, said first frame and said second frame each including one unit of said logical subdivision of said data, said first frame and said second frame do not overlap, and said first frame is imported from a second machine; and a monitor to permit a user to visually compare said first frame with said second frame.

An embodiment of the invention includes a system, comprising: a machine; an input port on the machine to receive data; a logical subdivision determiner to identify a logical subdivision of said data; an event identifier to identify an event of interest; a filter to eliminate any frames in said data not associated with the event of interest before identifying said first frame and said second frame; a frame identifier to identify a first frame and a second frame in said data, said first frame and said second frame each including one unit of said logical subdivision of said data and said first frame and said second frame do not overlap; and a monitor to permit a user to visually compare said first frame with said second frame.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; an operator to perform an operation on each of said first frame and said second frame, producing a first result and a second result, respectively; and a monitor to permit a user to visually compare said first result with said second result.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; an operator to perform a Fourier transform on each of said first frame and said second frame, producing a first result and a second result, respectively; and a monitor to permit a user to visually compare said first result with said second result.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; an operator to perform an operation on both said first frame and said second frame, producing a third result; and a monitor to permit a user to visually review the third result, thereby comparing said first frame and said second frame.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; and a monitor to permit a user to visually compare said first frame with said second frame, wherein the input port receives from said user said logical subdivision of said data for the logical subdivision determiner.

An embodiment of the invention includes a system, comprising: a machine; an input port on the machine to receive data; a logical subdivision determiner to identify a logical subdivision of said data, said logical subdivision including a packet; a frame identifier to identify a first frame and a second frame in said data, said first frame and said second frame each including one unit of said logical subdivision of said data and said first frame, said second frame do not overlap, and said first frame and said second frame are each packets in said data; and a monitor to permit a user to visually compare said first frame with said second frame.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; and a monitor to permit a user to visually compare said first frame with said second frame as both raw data and interpreted data.

An embodiment of the invention includes a system, comprising: a machine; an input port on the machine to receive data; a logical subdivision determiner to identify a logical subdivision of said data; a filter to filter said data; a frame identifier to identify a first frame and a second frame in said data, said first frame and said second frame each including one unit of said logical subdivision of said data and said first frame and said second frame do not overlap; and a monitor to permit a user to visually compare said first frame with said second frame.

An embodiment of the invention includes a system, comprising: a machine; an input port on the machine to receive data; a logical subdivision determiner to identify a logical subdivision of said data; a filter to eliminate any frames from the data that represent dead time before identifying said first frame and said second frame; a frame identifier to identify a first frame and a second frame in said data, said first frame and said second frame each including one unit of said logical subdivision of said data and said first frame and said second frame do not overlap; and a monitor to permit a user to visually compare said first frame with said second frame.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; a frame adjuster to adjust at least one of said first frame and said second frame to correct for misalignment; and a monitor to permit a user to visually compare said first frame with said second frame.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; a frame adjuster to adjust at least one of said first frame and said second frame to a known start of said at least one of said first frame and said second frame; and a monitor to permit a user to visually compare said first frame with said second frame.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; a frame adjuster to adjust at least one of said first frame and said second frame to correct for misalignment, including a calculator to calculate a difference between said first frame and said second frame for at least two adjustments to said at least one of said first frame and said second frame, a minimum difference identifier to identify a minimum difference among said differences, and the frame adjuster is operative to adjust said at least one of said first frame and said second frame based on said identified minimum difference; and a monitor to permit a user to visually compare said first frame with said second frame.

An embodiment of the invention includes a system, comprising: a machine; an input port on the machine to receive data; a logical subdivision determiner to identify a logical subdivision of said data; a frame identifier to identify a first frame and a second frame in said data, said first frame and said second frame each including one unit of said logical subdivision of said data and said first frame and said second frame do not overlap; a monitor to permit a user to visually compare said first frame with said second frame; an operator to perform an operation on said first frame to produce a first result; storage in the machine to store said first frame and said first result; a frame comparator to compare a third frame with said first frame to determine if said third frame is identical to said first frame; and if said third frame is identical to said first frame, a retriever retrieving said first result from the storage, and a storage to store said first result in the storage as a third result of performing said operation on said third frame.

An embodiment of the invention includes a method, comprising: receiving, at a machine, a data; identifying, at the machine, a logical subdivision of the data; identifying, at the machine, a first frame and a second frame of the data, the first frame and the second frame not overlapping; and visually comparing, with the machine, the first frame and the second frame.

An embodiment of the invention includes a method, comprising: receiving, at a machine, a data; identifying, at the machine, a logical subdivision of the data; identifying, at the machine, a first frame and a second frame of the data, including importing the first frame from a second machine, the first frame and the second frame not overlapping; and visually comparing, with the machine, the first frame and the second frame.

An embodiment of the invention includes a method, comprising: receiving, at a machine, a data; identifying, at the machine, a logical subdivision of the data, including identifying, at the machine, packets in the data; filtering the data based on at least one of header information and data content in the packets in the data; identifying, at the machine, a first frame and a second frame of the data, the first frame and the second frame not overlapping; and visually comparing, with the machine, the first frame and the second frame.

An embodiment of the invention includes a method, comprising: receiving, at a machine, a data; identifying, at the machine, a logical subdivision of the data, including identifying, at the machine, video frames in the data; filtering the data based on at least one of line numbers and video content in the video frames; identifying, at the machine, a first frame and a second frame of the data, the first frame and the second frame not overlapping; and visually comparing, with the machine, the first frame and the second frame.

An embodiment of the invention includes a method, comprising: receiving, at a machine, a data; identifying, at the machine, a logical subdivision of the data, including identifying, at the machine, a waveform in the data, the waveform based on at least one of a number of cycles, a specified time duration, and a pulse including specific characteristics; filtering the data based on a waveform characteristic; identifying, at the machine, a first frame and a second frame of the data, the first frame and the second frame not overlapping; and visually comparing, with the machine, the first frame and the second frame.

An embodiment of the invention includes a method, comprising: receiving, at a machine, a data; identifying, at the machine, a logical subdivision of the data, including identifying, at the machine, a waveform in the data, the waveform based on at least one of a number of cycles, a specified time duration, and a pulse including specific characteristics; filtering the data based on a waveform characteristic; identifying, at the machine, a first frame and a second frame of the data, the first frame and the second frame not overlapping; and visually comparing, with the machine, the first frame and the second frame, wherein the waveform used to identify the logical subdivision of the data is received from an alternate, secondary signal.

An embodiment of the invention includes a method, comprising: receiving, at a machine, a data; identifying, at the machine, a logical subdivision of the data; identifying, at the machine, a first frame and a second frame of the data, the first frame and the second frame not overlapping; identifying the second frame as being within a threshold of difference from the first frame; and visually comparing, with the machine, the first frame and the second frame.

An embodiment of the invention includes a method, comprising: receiving, at a machine, a data; identifying, at the machine, a logical subdivision of the data; identifying, at the machine, a first frame and a second frame of the data, the first frame and the second frame not overlapping, including importing the first frame from a second machine; identifying the second frame as being within a threshold of difference from the first frame, including identifying the second frame as a frame in the data that is closest to the first frame; and visually comparing, with the machine, the first frame and the second frame.

An embodiment of the invention includes a method, comprising: receiving, at a machine, a data; identifying, at the machine, a logical subdivision of the data; identifying, at the machine, a first frame and a second frame of the data, the first frame and the second frame not overlapping; performing an operation on each of the first frame and the second frame, producing a first result and a second result, respectively; and visually comparing, with the machine, the first frame and the second frame including visually comparing, with the machine, the first result and the second result.

An embodiment of the invention includes a method, comprising: receiving, at a machine, a data; identifying, at the machine, a logical subdivision of the data; identifying, at the machine, a first frame and a second frame of the data, the first frame and the second frame not overlapping; performing an operation on both the first frame and the second frame, producing a third result; and visually comparing, with the machine, the first frame and the second frame including visually comparing, with the machine, the third result, thereby comparing the first frame and the second frame.

An embodiment of the invention includes a method, comprising: receiving, at a machine, a data; identifying, at the machine, a logical subdivision of the data; identifying, at the machine, a first frame and a second frame of the data, the first frame and the second frame not overlapping; performing a Fourier transform on each of the first frame and the second frame, producing a first result and a second result, respectively; and visually comparing, with the machine, the first frame and the second frame including visually comparing, with the machine, the first result and the second result.

An embodiment of the invention includes a method, comprising: receiving, at a machine, a data; identifying, at the machine, a logical subdivision of the data; identifying, at the machine, a first frame and a second frame of the data, the first frame and the second frame not overlapping, including identifying an event of interest and eliminating any frames not associated with the event of interest before identifying the first frame and the second frame; and visually comparing, with the machine, the first frame and the second frame.

An embodiment of the invention includes a method, comprising: receiving, at a machine, a data; identifying, at the machine, packets in the data; identifying, at the machine, a first packet and a second packet of the data, the first packet different from the second packet; and visually comparing, with the machine, the first packet and the second packet.

An embodiment of the invention includes a method, comprising: receiving, at a machine, a data; identifying, at the machine, a logical subdivision of the data; identifying, at the machine, a first frame and a second frame of the data, the first frame and the second frame not overlapping; visually comparing, with the machine, the first frame and the second frame as raw data; and visually comparing, with the machine, the first frame and the second frame as interpreted data.

An embodiment of the invention includes a method, comprising: receiving, at a machine, a data; identifying, at the machine, a logical subdivision of the data; filtering the data; identifying, at the machine, a first frame and a second frame of the data, the first frame and the second frame not overlapping; and visually comparing, with the machine, the first frame and the second frame.

An embodiment of the invention includes a method, comprising: receiving, at a machine, a data; identifying, at the machine, a logical subdivision of the data; identifying, at the machine, a first frame and a second frame of the data, the first frame and the second frame not overlapping; and visually comparing, with the machine, the first frame and the second frame, including performing an operation using both the first frame and the second frame to compare the first frame and the second frame.

An embodiment of the invention includes a method, comprising: receiving, at a machine, a data; identifying, at the machine, a logical subdivision of the data; eliminating any frames that represent dead time before identifying the first frame and the second frame identifying, at the machine, a first frame and a second frame of the data, the first frame and the second frame not overlapping; and visually comparing, with the machine, the first frame and the second frame.

An embodiment of the invention includes a method, comprising: receiving, at a machine, a data; identifying, at the machine, a logical subdivision of the data; identifying, at the machine, a first frame and a second frame of the data, the first frame and the second frame not overlapping; adjusting at least one of the first frame and the second frame to correct for misalignment before visually comparing the first frame and the second frame; and visually comparing, with the machine, the first frame and the second frame.

An embodiment of the invention includes a method, comprising: receiving, at a machine, a data; identifying, at the machine, a logical subdivision of the data; identifying, at the machine, a first frame and a second frame of the data, the first frame and the second frame not overlapping; aligning at least one of the first frame and the second frame to a known start of the at least one of the first frame and the second frame; and visually comparing, with the machine, the first frame and the second frame.

An embodiment of the invention includes a method, comprising: receiving, at a machine, a data; identifying, at the machine, a logical subdivision of the data; identifying, at the machine, a first frame and a second frame of the data, the first frame and the second frame not overlapping; adjusting at least one of the first frame and the second frame to correct for misalignment before visually comparing the first frame and the second frame, including: calculating a difference between the first frame and the second frame for at least two adjustments to the at least one of the first frame and the second frame, identifying a minimum difference among the differences, and determining an adjustment to at least one of the first frame and the second frame based on the identified minimum difference; and visually comparing, with the machine, the first frame and the second frame.

An embodiment of the invention includes a method, comprising: receiving, at a machine, a data; identifying, at the machine, a logical subdivision of the data; identifying, at the machine, a first frame and a second frame of the data, the first frame and the second frame not overlapping; visually comparing, with the machine, the first frame and the second frame; performing an operation on the first frame, producing a first result; storing the first frame and the first result; identifying a third frame that is identical to the first frame; retrieving the stored first result; and storing the first result as a third result as performing the operation on the third frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, including importing the first frame from a second machine, the first frame and the second frame not overlapping; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data, including identifying, at the machine, packets in the data; filtering the data based on at least one of header information and data content in the packets in the data; identifying, at the machine, a first frame and a second frame of the data, the first frame and the second frame not overlapping; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data, including identifying, at the machine, video frames in the data; filtering the data based on at least one of line numbers and video content in the video frames; identifying, at the machine, a first frame and a second frame of the data, the first frame and the second frame not overlapping; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data, including identifying, at the machine, a waveform in the data, the waveform based on at least one of a number of cycles, a specified time duration, and a pulse including specific characteristics; filtering the data based on a waveform characteristic; identifying, at the machine, a first frame and a second frame of the data, the first frame and the second frame not overlapping; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data, including identifying, at the machine, a waveform in the data, the waveform based on at least one of a number of cycles, a specified time duration, and a pulse including specific characteristics; filtering the data based on a waveform characteristic; identifying, at the machine, a first frame and a second frame of the data, the first frame and the second frame not overlapping; and visually comparing, with the machine, the first frame and the second frame, wherein the waveform used to identify the logical subdivision of the data is received from an alternate, secondary signal.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; identifying the second frame as being within a threshold of difference from the first frame; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping, including importing the first frame from a second machine; identifying the second frame as being within a threshold of difference from the first frame, including identifying the second frame as a frame in the data that is closest to the first frame; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; performing an operation on each of the first frame and the second frame, producing a first result and a second result, respectively; and visually comparing, with the machine, the first frame and the second frame including visually comparing, with the machine, the first result and the second result.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; performing an operation on both the first frame and the second frame, producing a third result; and visually comparing, with the machine, the first frame and the second frame including visually comparing, with the machine, the third result, thereby comparing the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; performing a Fourier transform on each of the first frame and the second frame, producing a first result and a second result, respectively; and visually comparing, with the machine, the first frame and the second frame including visually comparing, with the machine, the first result and the second result.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping, including identifying an event of interest and eliminating any frames not associated with the event of interest before identifying the first frame and the second frame; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, packets in the data; identifying, at the machine, a first packet and a second packet of the data, the first packet different from the second packet; and visually comparing, with the machine, the first packet and the second packet.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; visually comparing, with the machine, the first frame and the second frame as raw data; and visually comparing, with the machine, the first frame and the second frame as interpreted data.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; filtering the data; identifying, at the machine, a first frame and a second frame of the data, the first frame and the second frame not overlapping; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; and visually comparing, with the machine, the first frame and the second frame, including performing an operation using both the first frame and the second frame to compare the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; eliminating any frames that represent dead time before identifying the first frame and the second frame identifying, at the machine, a first frame and a second frame of the data, the first frame and the second frame not overlapping; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; adjusting at least one of the first frame and the second frame to correct for misalignment before visually comparing the first frame and the second frame; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; aligning at least one of the first frame and the second frame to a known start of the at least one of the first frame and the second frame; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; adjusting at least one of the first frame and the second frame to correct for misalignment before visually comparing the first frame and the second frame, including: calculating a difference between the first frame and the second frame for at least two adjustments to the at least one of the first frame and the second frame, identifying a minimum difference among the differences, and determining an adjustment to at least one of the first frame and the second frame based on the identified minimum difference; and visually comparing, with the machine, the first frame and the second frame.

An embodiment of the invention includes an article, comprising a non-transitory storage medium, said non-transitory storage medium having stored thereon instructions that, when executed by a machine, result in: receiving, at a machine, a data; identifying, at the machine, a logical subdivision of the data; identifying, at the machine, a first frame and a second frame of the data, the first frame and the second frame not overlapping; visually comparing, with the machine, the first frame and the second frame; performing an operation on the first frame, producing a first result; storing the first frame and the first result; identifying a third frame that is identical to the first frame; retrieving the stored first result; and storing the first result as a third result as performing the operation on the third frame.

Consequently, in view of the wide variety of permutations to the embodiments described herein, this detailed description and accompanying material is intended to be illustrative only, and should not be taken as limiting the scope of the invention. What is claimed as the invention, therefore, is all such modifications as may come within the scope of the following claims and equivalents thereto.

## Claims

1. A system, comprising:
a machine;
an input port on the machine to receive data;
a logical subdivision determiner to identify a logical subdivision of said data;
a frame identifier to identify a first frame and a second frame in said data, said first frame and said second frame each including one unit of said logical subdivision of said data and said first frame and said second frame do not overlap; and
a monitor to permit a user to visually compare said first frame with said second frame.

2. A system according to claim 1, wherein:
said logical subdivision includes a packet; and
the system further includes a filter to filter said data based on at least one of header information and data content in packets in said data.

3. A system according to claim 1, wherein:
said logical subdivision includes a video frame; and
the system further includes a filter to filter said data based on at least one of line numbers and video content in video frames in said data.

4. A system according to claim 1, wherein:
said logical subdivision includes a waveform, the waveform based on at least one of a number of cycles, a specified time duration, and a pulse including specific characteristics; and
the system further includes a filter to filter said data based on a waveform characteristic.

5. A system according to any of claims 1 to 4, the system further includes a filter to identify said second frame as being within a threshold of difference from said first frame.

6. A system according to any of claims 1 to 5, further comprising:
an event identifier to identify an event of interest; and
a filter to eliminate any frames in said data not associated with the event of interest before identifying said first frame and said second frame.

7. A system according to any of claims 1 to 6, wherein:
the system further comprises an operator to perform an operation on each of said first frame and said second frame, producing a first result and a second result, respectively; and
the monitor permits said user to visually compare said first result with said second result.

8. A method, comprising:
receiving, at a machine, a data;
identifying, at the machine, a logical subdivision of the data;
identifying, at the machine, a first frame and a second frame of the data, the first frame and the second frame not overlapping; and
visually comparing, with the machine, the first frame and the second frame.

9. A method according to claim 8, wherein identifying, at the machine, a first frame and a second frame of the data includes importing the first frame from a second machine.

10. A method according to claim 8, wherein:
identifying, at the machine, a logical subdivision of the data includes identifying, at the machine, packets in the data; and
the method further comprises filtering the data based on at least one of header information and data content in the packets in the data.

11. A method according to claim 8, wherein:
identifying, at the machine, a logical subdivision of the data includes identifying, at the machine, video frames in the data; and
the method further comprises filtering the data based on at least one of line numbers and video content in the video frames.

12. A method according to claim 8, wherein:
identifying, at the machine, a logical subdivision of the data includes identifying, at the machine, a waveform, the waveform based on at least one of a number of cycles, a specified time duration, and a pulse including specific characteristics; and
the method further comprises filtering the data based on a waveform characteristic.

13. A method according to claim 12, wherein identifying, at the machine, a waveform includes identifying, at the machine, the waveform, the waveform used to identify the logical subdivision of the data received from an alternate, secondary signal.

14. A method according to any of claims 8 to 13, further comprising identifying the second frame as being within a threshold of difference from the first frame.

15. A method according to claim 8, wherein identifying, at the machine, a first frame and a second frame of the data, includes:
identifying an event of interest; and
eliminating any frames not associated with the event of interest before identifying the first frame and the second frame.
